# EUROPEAN PATENT SPECIFICATION

(11) **EP 3 496 250 B1**
(45) Date of publication and mention of the grant of the patent: **11.05.2022**
(21) Application number: 17205435.5
(22) Date of filing: 05.12.2017
(51) Int. Cl.: H02M 7/5387, H02M 1/08, H02M 1/32, H03K 17/06, H03K 17/082

(54) **INVERTER, ASSEMBLY AND VEHICLE COMPRISING SUCH INVERTER, AND METHOD FOR OPERATING AN INVERTER**
WECHSELRICHTER, ANORDNUNG UND FAHRZEUG MIT SOLCH EINEM WECHSELRICHTER UND VERFAHREN ZUM BETRIEB EINES WECHSELRICHTERS
ONDULEUR, ENSEMBLE ET VÉHICULE COMPORTANT UN TEL ONDULEUR ET PROCÉDÉ POUR FAIRE FONCTIONNER UN ONDULEUR

(43) Date of publication of application: 12.06.2019
(73) Proprietor: Valeo Siemens eAutomotive Germany GmbH, 91056 Erlangen (DE)
(72) Inventor: BOHLLÄNDER, Marco, 96114 Hirschaid (DE)

(56) References cited:
- EP-A2- 2 747 260
- US-A1- 2014 247 000
- US-A1- 2017 093 323

## Description

The invention relates to an inverter, in particular for an electric machine. Besides, the invention relates to an assembly comprising an electric machine and said inverter, a vehicle and a method for operating an inverter.

EP 2 747 260 A2 discloses an electrical power rectifier comprising at least two branches that are connected in parallel to each other, each of said branches comprising at least two power semiconductor elements connected in series, a control device for activating the power semiconductor elements, and means for detecting the collector-emitter voltage V_{CE}(t) and/or the collector current lc(t) of at least one of the power semiconductor elements. The control device is adapted to use the detected collector-emitter voltage V_{CE}(t) and/or the collector current lc(t) of the at least one of the power semiconductor elements to determine whether at least one of the following conditions is met: dV_{CE}(t)/dt < (dVc_{E}/dt)_{crit} and/or dlc(t)/dt < (dlc/dt)crit and/or lc(t_ent + delta t) < I_{Ccrit}. The control device is further adapted to increase the gate-emitter voltage of at least one of the power semiconductor elements if it is determined that at least one of the aforementioned conditions is met.

US 2017/093323 A1 discloses an inverter control device for controlling a rotating electric machine drive device that includes an inverter and a DC link capacitor, the inverter being connected to a DC power supply via a contactor, being connected to an alternating current rotating electric machine, and performing power conversion between direct current and three-phase alternating current, an arm for each alternating current phase being formed by a series circuit including an upper side switching element and a lower side switching element, and the DC link capacitor smoothing a DC link voltage, which is a DC-side voltage of the inverter, the inverter control device performing switching control on the switching elements that form the inverter. The inverter control device comprises: an electronic control unit that includes control logic, which when executed: executes partial shutdown control in which a switching element in an on state in a target arm that is an arm of any one phase is switched to an off state when the contactor enters an open state during rotation of the rotating electric machine, and thereafter executes full shutdown control in which, when currents in the arms of two phases different from the target arm both become zero, switching elements in the on state in all remaining arms are switched to the off state.

US 2014/0247000 A1 discloses to short-circuit motor windings of an electric machine safely in the event of a fault by closing all high-side switches and opening all low-side switches, which is also referred to as an "active short circuit".

Inverters are widely used for converting a DC voltage obtained from a DC link into an AC output voltage for supplying stator windings of an electric machine. Therefore, the inverter comprises a plurality of switching elements controllable by a controller which provides a, e. g. pulse-width-modulated, pattern for operating the inverter in a pulsing mode. In several cases the inverter has to be put into an active short circuit mode (ASC) in which at least a part of phases of the electric machine are shortcircuited inside the inverter by a suitable configuration of switching states of the switching elements. Within a short period of e. g. 10 to 15 milliseconds after adopting the active short circuit mode, high transient currents may flow through the switching path of the switching elements. The currents are higher than currents flowing during a normal, including an overload, operation of the inverter, e.g. during a pulsing mode, and may cause an undesired operation of the switching elements in an active region, where a current flowing through the switching path depends substantially on a voltage applied to a control terminal of the switching element. Disadvantageously, the benefits of the active short circuit mode cannot be achieved when a switching element is operated in the active region because the switching elements may be damaged due to the operation in the active region.

To overcome these problems it has been proposed to put the switching elements in a so called "safe pulse off" mode in which all switching elements are in a blocking switching state for several ten to hundred milliseconds and to put the inverter into the active short circuit mode afterwards. This reduces the transient currents in the active short circuit mode. Alternatively, the inverter has to be designed with such redundancies that the transient current in the active short circuit mode does not result in an operation of the switching elements in the active region. Nevertheless, such a design renders the inverter more expensive.

Thus, it is an object of the present invention to provide an alternative possibility to operate an inverter more robustly and/or with less effort.

The above object is solved by the features of claims 1, 10, 11 and 12. Embodiments of the invention are defined by the features of the dependent claims.

According to a first aspect of the invention an inverter according to claim 1 is provided.

The present invention is based upon the consideration that an operation of the group of switching elements in the active region can be prevented by increasing the absolute value of the voltage to the control terminals, resulting in a shift of the switching elements' operating point. At this operating point, the switching element remains outside the active region even when a high current flows through a switching path of the switching elements. Advantageously, this strategy avoids an operation of the respective switching elements in the active region without the necessity to operate the inverter in the safe pulse off mode before applying the active short circuit or to redesign the inverter with high effort. Additionally, applying the active short circuit mode avoids overvoltages in a DC link of the inverter, which may occur in a safe pulse off mode.

According to the invention, each switching element is a power transistor with an insulated gate field-effect transistor structure, particularly a metal-oxide-semiconductor field-effect transistor (MOSFET) structure, or a junction field-effect transistor (JFET) structure. Typically, the control terminal is a gate terminal.

With respect to insulated gate field-effect transistors and JFET as switching elements the active region may be considered as a saturation region of an output characteristic. Particularly, when the switching element is not operated in the active region an insulated gate filed-effect transistor or a JFET is operated in a linear region (also known triode region) of the output characteristics when being conducting. The active region may be considered as a region of the output characteristics, in which a voltage across the switching element varies highly with the current flowing through a switching path of the switching element depends substantially on a voltage applied to a control terminal of the switching element.

The pulsing unit may comprise a modulator for generating signals by which the sequences of the first voltage and the second voltage are applicable to the control terminals. Typically, the pulsing unit provides signals having high and low levels which are amplified to the first voltage or the second voltage, respectively, by a driver unit connected to the control terminal of each switching element. In particular, said sequences of the first voltage and the second voltage implement a Pulse Width Modulation signal. Preferably, the short circuit unit is configured to switch switching elements not belonging to the group of switching elements to the second switching state for putting the inverter to the active short circuit mode. Typically, the first switching state is different from the second switching state. Usually, the first voltage causes a switching element to be in a conducting switching state and the second voltage causes the switching element to be in a blocking switching state. In other words, the first switching state may be the conducting switching state and the second switching state may be the blocking switching state of a respective switching element.

With respect to the inverter it is preferred, that the absolute value of the third voltage is at least 5 %, particularly at least 10 %, higher than the absolute value of the first voltage. Assuming a typical first voltage for setting a switching element to the conducting switching state of about 15 volts the third voltage is exemplarily chosen to 17 volts. The specific values of the first, second and third voltage may be chosen by a person skilled in the art depending on the operation characteristics, particularly the output characteristics, of the switching elements.

Preferably, the control terminal of each switching element of the group of switching elements is connected to a boosting unit comprising an energy source connectable to the control terminal for applying the third voltage. Thus, the boosting unit may be controllable by the inverter, particularly the short circuit unit, to be triggered when the third voltage is to be applied.

Particularly, the energy source comprises an energy storage chargeable to an amount of charge for reaching the third voltage on the control terminal. The energy storage may be a capacitor. It is preferred, that the energy storage is dimensioned such that a capacity of the control terminal, particularly a gate capacity may be charged to the third voltage. The energy storage may further be dimensioned such that the third voltage may be held for a predefined time span, e. g. for 500 milliseconds. After the time span, the high transient currents have typically decayed to a value that allows a switching element to be in the first switching state by applying the first voltage without being operated in the active region.

Furthermore, the boosting unit may comprise a switch configured to connect the energy source to the control terminal when putting the inverter into the active short circuit mode. The switch may be controlled by the short circuit unit. The switch may be controlled to be closed for the time span within which the application of the third voltage is desired.

Preferably, the control terminal of each switching element of the group of switching elements is connected to a driver unit, wherein the driver unit is configured to amplify signals of the pulsing unit to the sequences of the first voltage and the second voltage in the pulsing mode, wherein the energy source is connectable to a node between the driver unit and the control terminal. The driver unit may comprise a diode connected to the control terminal side of the driver unit and allowing a current to flow into the control terminal.

With respect to the inverter according to the invention, it is preferred that the controller is configured to trigger the short circuit unit to put the inverter into the active short circuit mode, when a failure is detected by the controller or an external signal is received by the controller. A failure may be an increase of the DC link voltage over a predefined threshold value. The external signal may be obtained from an external electric control unit (ECU) of the vehicle.

According to the invention, the switching elements are arranged in half bridges, in particular for each phase of an electric machine supplied by the inverter, wherein the group comprises either all switching elements connected to a high potential of an inverter's DC link or all switching elements connected to a low potential of an inverter's DC link. If the group comprises all respective switching elements, a full active short circuit is performed. After having adopted the active short circuit mode, the adopted switching configuration may be held. Typically, the short circuit unit is configured to switch the switching elements connected to the inverse potential regarding to the group of switching elements, into the second switching state, particularly into the blocking switching state.

Furthermore, the inverter may comprise an active region handling unit configured to detect an operation of a switching element in an active region and to switch the switching element, for which the operation in the active region has been detected, or all switching elements into a blocking state if the operation in the active region has been detected. Such an active region handling unit allows to monitor the switching elements independently from putting the inverter into is active short circuit mode. However, an operation in the active region occurring when putting conventional inverters to the active short circuit mode will cause the active region handling unit to switch the switching element, for which the operation the active region has been detected, to the blocking switching state. With respect to a conventional inverter the active short circuit is thus inhibited by the active region handling unit as the switching element, for which the operation in the active region has been detected, may have to be conducting for realizing the active short circuit. Thus, the invention allows the usage of an active region handling unit in combination with an immediate active short circuit, particularly after having detected a failure or having received the external signal.

According to a second aspect the invention relates to an assembly comprising an electric machine, particularly for driving a vehicle, comprising a stator with stator windings, and the inventive inverter configured to provide an AC voltage to the stator windings. Preferably, the electric machine is a permanent-magnet synchronous machine.

According to a third aspect the invention relates to a vehicle, comprising the inventive assembly.

According to a fourth aspect the invention relates to a method according to claim 12.

All statements referring to the inventive inverter apply analogously to the inventive assembly, the inventive vehicle and the inventive method, so that the above-mentioned advantages of the inventive inverter may be achieved as well.

Further details and advantages of the invention are disclosed in the following, whereby reference is made to the schematic drawings showing:
- Fig. 1: a schematic diagram of an embodiment of an assembly according to the invention with an inventive inverter;
- Fig. 2: a characteristic output curve of a switching element of the inverter depicted in Fig. 1; and
- Fig. 3: a schematic diagram of a driver unit and a boosting unit connected to a switching element of the inverter depicted in Fig. 1;
- Fig. 4: a schematic drawing of a vehicle according to the invention.

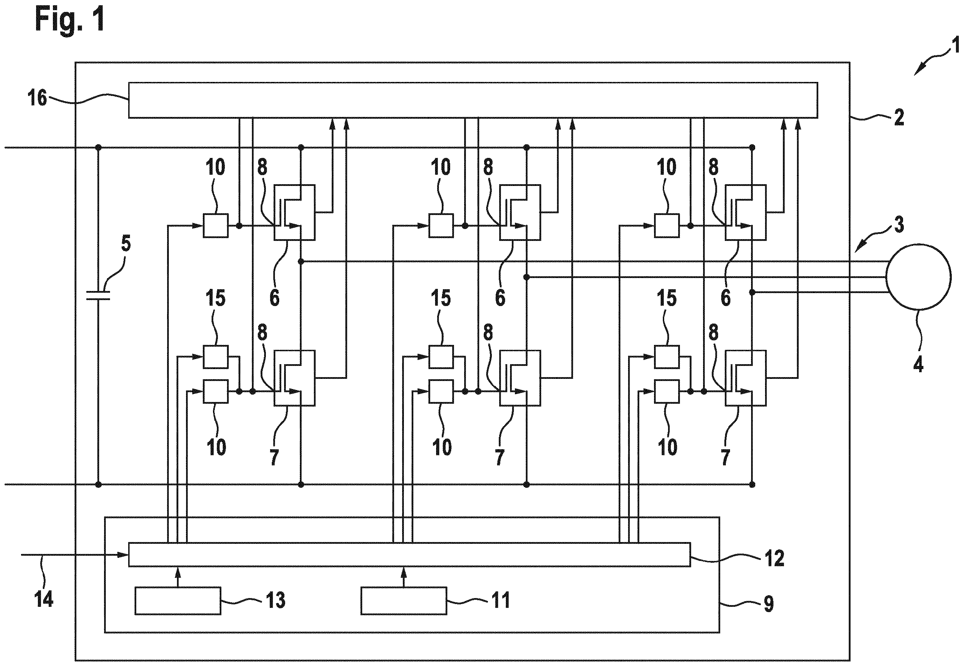

Fig. 1 is a block diagram of an embodiment of an assembly 1 comprising an electric machine 4 having a stator with stator windings, and an inverter 2 with an AC output 3 connected to the phases of the electrical machine 4. Preferably, the electric machine 1 is a permanent-magnet synchronous machine.

The inverter 2 comprises a DC link with a capacitor 5 and a plurality of switching elements 6, 7 arranged in a half bridge for each phase of the electric machine 4. Each switching element 6, 7 is voltage-controlled, e. g. an insulated gate field-effect transistor, particularly a metal oxide semiconductor field-effect transistor (MOSFET), or an junction field-effect transistor (JFET). The switching elements 6 are connected to a high potential of the DC link, and the switching elements 7 are connected to a low potential of the DC link. Each switching element 6, 7 comprises a control terminal 8, particularly a gate terminal.

Furthermore, the inverter 2 comprises a controller 9 configured to control the control terminals 8 of the switching elements 6, 7 via driver units 10 each connected between a port of the controller 9 and the respective control terminal 8. The controller 9 comprises a pulsing unit 11 which provides signals, in particular pulse-width-modulated signals, according to which the switching elements 6, 7 adopt a first, conducting switching state or a second, blocking switching state. The signals provided by the pulsing unit 11 are fed into a short circuit unit 12 of the controller 9. In a pulsing operation mode of the inverter 2 the signals provided by the pulsing unit 11 pass through the short circuit unit 12 and are fed into the driver units 10. Additionally, the control terminal 8 of each switching element 7 is connected to a boosting unit 15 controllable by the short circuit unit 12.

In the case of a failure detected by a failure detection unit 13 of the controller 9 or upon request by an external signal 14, the short circuit unit 12 puts the inverter 2 into an active short circuit mode. In this mode the switching elements 7 connected to the low potential are switched to the first switching state and the switching elements 6 on the high potential are switched to the second switching state.

Additionally, the inverter 2 comprises an active region handling unit 16 configured to detect an operation of the switching elements 6, 7 in an active region of output characteristics and to switch a switching element 6, 7, for which the operation in the active region has been detected, to the second switching state in order to protect the inverter 2.

Note, that the functions of the pulsing unit 11, short circuit unit 12, the failure detection unit 13 and the active region handling unit 16 may be implemented in one or more pieces of control hardware, e.g. a microcontroller or other control circuitry. Particularly, the implementation may be functionally distributed over several pieces of control hardware. Thus, a respective unit may be a section of a program being implemented.

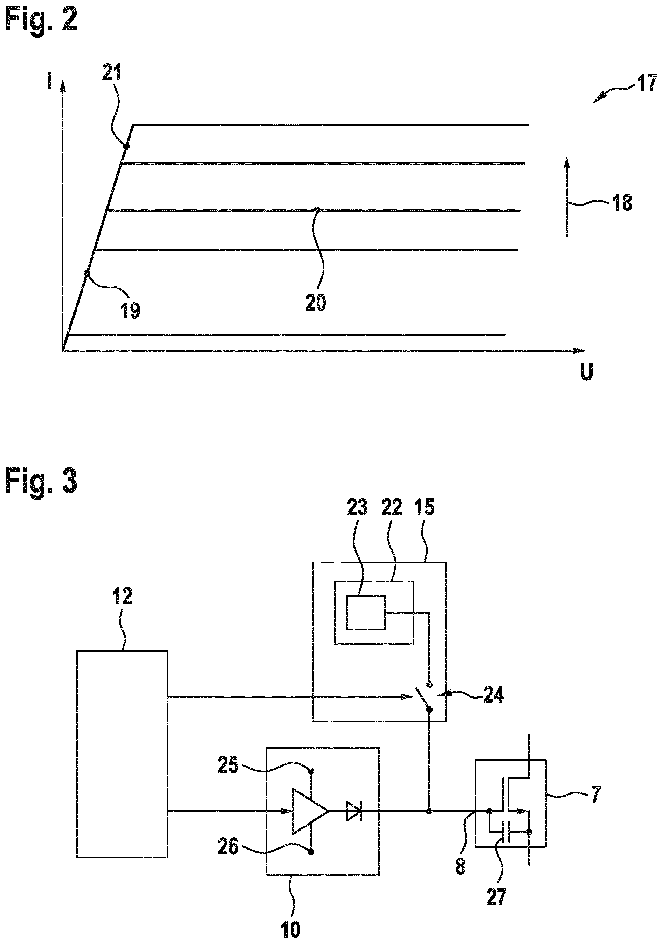

Fig. 2 is an output characteristics curve 17 of the switching elements 6, 7 depicting a current I over a voltage U dropping over the switching path depending on a voltage provided to the control terminal 8 (represented by an arrow 18). Thereby, the curve refers to a characteristic output of a MOSFET and may apply analogously to the characteristic output of other insulated gate field-effect transistors or JFET.

In the pulsing mode of the inverter 2 the first switching state refers to an operating point 19. With respect to an insulated gate field-effect transistor or a JFET as switching elements 6, 7 the operating point 19 is in a linear region (also called triode region). However, when putting the inverter 2 to the active short circuit mode a high transient current may flow through the switching path which may cause the switching element 7 to be operated at an operating point 20 in the active region. As such an operation in the active region is undesired, the boosting unit 15 is configured to apply a third voltage which is higher than the first voltage provided by the driver unit 10 to the control terminal 8. By applying the third voltage the switching element 6, 7 may be operated at an operating point 21 capable of conducting the high transient currents outside the active region.

Fig. 3 is a block diagram of one of the switching elements 7 connected to the driver unit 10 and the boosting unit 15. The boosting unit 15 comprises an energy source 22 with an energy storage 23 such as a capacitor. Additionally, the boosting unit 15 comprises a switch 24 controllable by the short circuit unit 12 and configured to connect the energy source 22 to the control terminal 8 by closing the switch 24. In the pulsing mode signals provided by the pulsing unit 11 pass through the short circuit unit 12. The short-circuit unit 12 controls the switch 24 to be opened. Consequently, the signals passing through the short circuit unit 12 are amplified by the driver unit 10 to a first voltage provided to a port 25 for setting the switching element 7 to the first switching state and to the second voltage provided to a port 26 for setting the switching element 7 to the second switching state.

When putting the inverter 2 into the active short circuit mode, the short circuit unit 12 inhibits the signals obtained from the pulsing unit 11, and applies a signal to the driver unit 10 to switch the switching element 7 to the first switching state. Additionally, the short circuit unit 12 triggers the closing of the switch 24. Thus, the energy source 22 is connected to the control terminal 8. The energy source 22 provides a third voltage to the control terminal 8 which causes a gate capacity 27 of the switching element 7 to be charged for reaching the operating point 21 (cf. fig. 2). In particular, the capacity of the energy storage 23 is chosen such that the required amount of charge is provided for a predetermined time span. Within the time span the high transient current flows through the switching path of the switching elements 7. The short circuit unit 12 may open the switch 24 after the time span or may remain the switch 24 closed. As the transient currents have decayed, the first voltage is sufficient to avoid the operation of the switching element 7 in the active region. Since the boosting unit 15 avoids the operation of the switching elements 7 in the active region an activation of the active region handling unit 16 when adopting the active short circuit mode is avoided, advantageously.

According to an embodiment of the assembly 1, in the active short circuit mode, the switching elements 6 connected to the high potential of the DC link are provided to be in the conducting switching state, and the switching elements 7 connected to the low potential of the DC link are provided to be in the blocking switching state. Thus, the boosting units 15 are connected to the switching elements 6 instead of being connected to the switching elements 7.

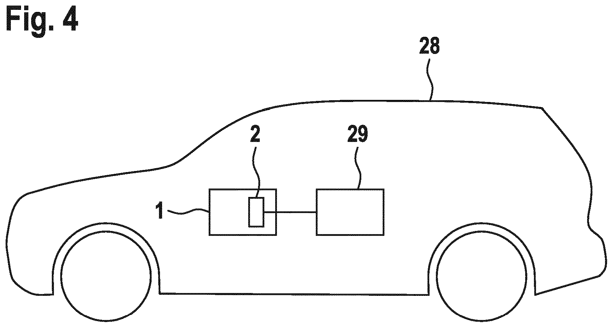

Fig. 4 is a schematic drawing of a vehicle 28, comprising the assembly 1 with the inverter 2. The inverter 2 is connected to a high voltage battery 29 providing a DC voltage and configured to convert the DC voltage for driving the vehicle 28.

## Claims

1. Inverter (2), in particular for an electric machine (4),
- with a DC link,
- with a plurality of voltage-controlled switching elements (6, 7) being arranged in half bridges and each being a power transistor with an insulated gate field-effect transistor structure or a junction field-effect transistor structure and
- with a controller (9) comprising
- a pulsing unit (11) configured for operating the inverter (2) in a pulsing mode in which sequences of a first voltage and a second voltage are applied to control terminals (8) of the switching elements (6, 7), the first voltage being configured for setting a switching element to a first switching state and the second voltage being configured for setting the switching element to a second switching state, and
- a short circuit unit (12) configured to put the inverter (2) into an active short circuit mode by switching a group of switching elements (7) to the first switching state, the group comprising either all switching elements connected to a high potential of the DC link or all switching elements (7) connected to a low potential of the DC link,
wherein in the active short circuit mode, the inverter (2) is configured to apply to the control terminals (8) of said group of switching elements (7) a third voltage having a higher absolute value than the absolute value of the first voltage.

2. Inverter (2) according to claim 1, **characterized in that** the absolute value of the third voltage is at least 5 %, particularly at least 10 %, higher than the absolute value of the first voltage.

3. Inverter (2) according to claim 1 or 2, **characterized in that** the control terminal (8) of each switching element (7) of the group of switching elements (7) is connected to a boosting unit (15) comprising an energy source (22) connectable to the control terminal (8) for applying the third voltage.

4. Inverter (2) according to claim 3, **characterized in that** the energy source (21) comprises an energy storage (23) chargeable to an amount of charge for reaching the third voltage on the control terminal (8).

5. Inverter (2) according to claim 3 or 4, **characterized in that** the boosting unit (15) comprises a switch (24) configured to connect the energy source (22) to the control terminal (8) when putting the inverter (2) into the active short circuit mode.

6. Inverter (2) according to any of claims 3 to 5, **characterized in that** the control terminal (8) of each switching element (7) of the group of switching elements (7) is connected to a driver unit (10), wherein the driver unit (10) is configured to amplify signals of the pulsing unit (11) to the sequences of the first voltage and the second voltage in the pulsing mode, wherein the energy source (21) is connectable to a node between the driver unit (10) and the control terminal (8).

7. Inverter (2) according to any of the preceding claims, **characterized in that** the controller (9) is configured to trigger the short circuit unit (12) to put the inverter (2) into the active short circuit mode, if a failure is detected by the controller (9) or an external signal (14) is received.

8. Inverter (2) according to any of the preceding claims, **characterized in that** the insulated gate field-effect transistor structure is a MOSFET structure.

9. Inverter (2) according to any of the preceding claims, **characterized by** an active region handling unit (16) configured to detect an operation of a switching element (6, 7) in an active region and to switch switching element, for which the operation in the active region has been detected, or all switching elements (6, 7) into a blocking switching state if the operation in the active region has been detected.

10. Assembly (1) comprising:
- an electric machine (4), in particular for a vehicle (28), comprising a stator with stator windings and
- an inverter (2) according to any of claims 1 to 9 configured to provide an AC voltage to the stator windings.

11. Vehicle (28), comprising an assembly (1) according to claim 10.

12. Method for operating an inverter (2) with a DC link and with a plurality of voltage-controlled switching elements (6, 7) being arranged in half bridges and each being a power transistor with an insulated gate field-effect transistor structure or a junction field-effect transistor structure, wherein the inverter (2) is operated in a pulsing mode in which sequences of a first voltage and a second voltage are applied to control terminals (8) of the switching elements (6, 7), said first voltage being configured for setting a switching element (6, 7) to a first switching state and said second voltage being configured for setting the switching element (6, 7) to a second switching state, whereafter the inverter (2) is put into an active short circuit mode by switching a group of switching elements (7) to the first switching state, owing to a third voltage applied to the control terminals (8) of the group of switching elements (7), said third voltage having a higher absolute value than the absolute value of the first voltage, the group comprising either all switching elements connected to a high potential of the DC link or all switching elements (7) connected to a low potential of the DC link.

## Patentansprüche

1. Wechselrichter (2), insbesondere für eine elektrische Maschine (4),
- mit einem Gleichspannungs-Zwischenkreis,
- mit einer Vielzahl von spannungsgesteuerten Schaltelementen (6, 7), die in Halbbrücken angeordnet sind und jeweils einen Leistungstransistor mit einer Isolierschicht-Feldeffekttransistorstruktur oder einer Sperrschicht-Feldeffekttransistorstruktur darstellen und
- mit einem Controller (9), der Folgendes umfasst:
- eine Pulsiereinheit (11), die für den Betrieb des Wechselrichters (2) in einem Pulsiermodus ausgebildet ist, in dem Sequenzen einer ersten Spannung und einer zweiten Spannung an Steueranschlüsse (8) der Schaltelemente (6, 7) angelegt werden, wobei die erste Spannung dazu ausgebildet ist, ein Schaltelement in einen ersten Schaltzustand zu versetzen, und die zweite Spannung dazu ausgebildet ist, das Schaltelement in einen zweiten Schaltzustand zu versetzen, und
- eine Kurzschlusseinheit (12) dazu ausgebildet ist, den Wechselrichter (2) in einen aktiven Kurzschlussmodus zu versetzen, indem sie eine Gruppe von Schaltelementen (7) in den ersten Schaltzustand schaltet, wobei die Gruppe entweder alle Schaltelemente umfasst, die mit einem hohen Potential des Gleichspannungs-Zwischenkreises verbunden sind, oder alle Schaltelemente (7), die mit einem niedrigen Potential des Gleichspannungs-Zwischenkreises verbunden sind,
wobei der Wechselrichter (2) im aktiven Kurzschlussmodus so ausgebildet ist, dass er an die Steueranschlüsse (8) der Gruppe von Schaltelementen (7) eine dritte Spannung anlegt, die einen höheren Absolutwert als der Absolutwert der ersten Spannung hat.

2. Wechselrichter (2) gemäß Anspruch 1, **dadurch gekennzeichnet, dass** der Absolutwert der dritten Spannung um mindestens 5 %, insbesondere um mindestens 10 %, höher ist als der Absolutwert der ersten Spannung.

3. Wechselrichter (2) gemäß Anspruch 1 oder 2, **dadurch gekennzeichnet, dass** der Steueranschluss (8) jedes Schaltelements (7) der Gruppe von Schaltelementen (7) mit einer Verstärkungseinheit (15) verbunden ist, die eine mit dem Steueranschluss (8) verbindbare Energiequelle (22) zum Anlegen der dritten Spannung umfasst.

4. Wechselrichter (2) gemäß Anspruch 3, **dadurch gekennzeichnet, dass** die Energiequelle (21) einen Energiespeicher (23) umfasst, der auf einen Ladungsbetrag zum Erreichen der dritten Spannung am Steueranschluss (8) aufladbar ist.

5. Wechselrichter (2) gemäß Anspruch 3 oder 4, **dadurch gekennzeichnet, dass** die Verstärkungseinheit (15) einen Schalter (24) umfasst, der so ausgebildet ist, dass er die Energiequelle (22) mit dem Steueranschluss (8) verbindet, wenn der Wechselrichter (2) in den aktiven Kurzschlussmodus versetzt wird.

6. Wechselrichter (2) gemäß einem der Ansprüche 3 bis 5, **dadurch gekennzeichnet, dass** der Steueranschluss (8) jedes Schaltelements (7) der Gruppe von Schaltelementen (7) mit einer Treibereinheit (10) verbunden ist, wobei die Treibereinheit (10) so ausgebildet ist, dass sie die Signale der Pulsiereinheit (11) auf die Sequenzen der ersten Spannung und der zweiten Spannung im Pulsiermodus verstärkt, wobei die Energiequelle (21) an einen Knoten zwischen der Treibereinheit (10) und dem Steueranschluss (8) anschließbar ist.

7. Wechselrichter (2) gemäß einem der vorhergehenden Ansprüche, **dadurch gekennzeichnet, dass** der Controller (9) so ausgebildet ist, dass er die Kurzschlusseinheit (12) auslöst, um den Wechselrichter (2) in den aktiven Kurzschlussmodus zu versetzen, wenn eine Störung durch den Controller (9) erkannt wird oder ein externes Signal (14) empfangen wird.

8. Wechselrichter (2) gemäß einem der vorhergehenden Ansprüche, **dadurch gekennzeichnet, dass** die Isolierschicht-Feldeffekttransistorstruktur eine MOSFET-Struktur ist.

9. Wechselrichter (2) gemäß einem der vorhergehenden Ansprüche, **gekennzeichnet durch** eine Aktivbereich-Handhabungseinheit (16), die so ausgebildet ist, dass sie eine Betätigung eines Schaltelements (6, 7) in einem Aktivbereich erkennt und ein Schaltelement, für das die Betätigung in dem Aktivbereich erkannt wurde, oder alle Schaltelemente (6, 7) in einen blockierenden Schaltzustand schaltet, wenn die Betätigung in dem Aktivbereich erkannt worden ist.

10. Baugruppe (1) bestehend aus:
- einer elektrischen Maschine (4), insbesondere für ein Fahrzeug (28), das einen Stator mit Statorwicklungen umfasst, und
- einem Wechselrichter (2) gemäß einem der Ansprüche 1 bis 9, der so ausgebildet ist, dass er den Statorwicklungen eine Wechselspannung zuführt.

11. Fahrzeug (28), das eine Baugruppe (1) gemäß Anspruch 10 umfasst.

12. Verfahren zum Betreiben eines Wechselrichters (2) mit einem Gleichspannungs-Zwischenkreis und mit einer Vielzahl von spannungsgesteuerten Schaltelementen (6, 7), die in Halbbrücken angeordnet sind und jeweils einen Leistungstransistor mit einer Isolierschicht-Feldeffekttransistorstruktur oder einer Sperrschicht-Feldeffekttransistorstruktur darstellen,
wobei der Wechselrichter (2) in einem Pulsiermodus betrieben wird, in dem Sequenzen einer ersten Spannung und einer zweiten Spannung an Steueranschlüsse (8) der Schaltelemente (6, 7) angelegt werden,
wobei die erste Spannung so ausgebildet ist, dass sie ein Schaltelement (6, 7) in einen ersten Schaltzustand versetzt, und die zweite Spannung so ausgebildet ist, dass sie das Schaltelement (6, 7) in einen zweiten Schaltzustand versetzt,
woraufhin der Wechselrichter (2) in einen aktiven Kurzschlussmodus versetzt wird, indem eine Gruppe von Schaltelementen (7) aufgrund einer an die Steueranschlüsse (8) der Gruppe von Schaltelementen (7) angelegten dritten Spannung in den ersten Schaltzustand geschaltet wird,
wobei die dritte Spannung einen höheren Absolutwert als der Absolutwert der ersten Spannung hat, wobei die Gruppe entweder alle Schaltelemente umfasst, die mit einem hohen Potential des Gleichspannungs-Zwischenkreises verbunden sind, oder alle Schaltelemente (7), die mit einem niedrigen Potential des Gleichspannungs-Zwischenkreises verbunden sind.

## Revendications

1. Onduleur (2), notamment pour une machine électrique (4),
- comportant une liaison DC,
- comportant une pluralité d'éléments de commutation commandés en tension (6, 7) qui sont disposés en demi-ponts et qui sont chacun un transistor de puissance ayant une structure de transistor à effet de champ à grille isolée ou une structure de transistor à effet de champ à jonction, et
- comportant un dispositif de commande (9) comprenant
- une unité de pulsation (11) configurée pour faire fonctionner l'onduleur (2) dans un mode pulsé dans lequel des séquences d'une première tension et d'une deuxième tension sont appliquées à des bornes de commande (8) des éléments de commutation (6, 7), la première tension étant configurée pour mettre un élément de commutation dans un premier état de commutation et la deuxième tension étant configurée pour mettre l'élément de commutation dans un deuxième état de commutation, et
- une unité de court-circuit (12) configurée pour mettre l'onduleur (2) dans un mode de court-circuit actif par la commutation d'un groupe d'éléments de commutation (7) dans le premier état de commutation, le groupe comprenant soit tous les éléments de commutation connectés à un potentiel haut de la liaison DC, soit tous les éléments de commutation (7) connectés à un potentiel bas de la liaison DC,
dans lequel, dans le mode de court-circuit actif, l'onduleur (2) est configuré pour appliquer aux bornes de commande (8) dudit groupe d'éléments de commutation (7) une troisième tension ayant une valeur absolue supérieure à la valeur absolue de la première tension.

2. Onduleur (2) selon la revendication 1, **caractérisé en ce que** la valeur absolue de la troisième tension est supérieure d'au moins 5 %, notamment d'au moins 10 %, à la valeur absolue de la première tension.

3. Onduleur (2) selon la revendication 1 ou 2, **caractérisé en ce que** la borne de commande (8) de chaque élément de commutation (7) du groupe d'éléments de commutation (7) est connectée à une unité de suralimentation (15) comprenant une source d'énergie (22) connectable à la borne de commande (8) pour appliquer la troisième tension.

4. Onduleur (2) selon la revendication 3, **caractérisé en ce que** la source d'énergie (21) comprend un accumulateur d'énergie (23) pouvant être chargé à une quantité de charge permettant d'atteindre la troisième tension sur la borne de commande (8).

5. Onduleur (2) selon la revendication 3 ou 4, **caractérisé en ce que** l'unité de survoltage (15) comprend un commutateur (24) configuré pour connecter la source d'énergie (22) à la borne de commande (8) lorsque l'onduleur (2) est mis en mode de court-circuit actif.

6. Onduleur (2) selon l'une quelconque des revendications 3 à 5, **caractérisé en ce que** la borne de commande (8) de chaque élément de commutation (7) du groupe d'éléments de commutation (7) est connectée à une unité d'attaque (10), dans lequel l'unité d'attaque (10) est configurée pour amplifier des signaux de l'unité de pulsation (11) en les séquences de la première tension et de la deuxième tension dans le mode de pulsation, dans lequel la source d'énergie (21) est connectable à un nœud entre l'unité d'attaque (10) et la borne de commande (8).

7. Onduleur (2) selon l'une quelconque des revendications précédentes, **caractérisé en ce que** le dispositif de commande (9) est configuré pour déclencher l'unité de court-circuit (12) afin qu'elle mette l'onduleur (2) en mode de court-circuit actif, si une défaillance est détectée par le dispositif de commande (9) ou si un signal externe (14) est reçu.

8. Onduleur (2) selon l'une quelconque des revendications précédentes, **caractérisé en ce que** la structure de transistor à effet de champ à grille isolée est une structure MOSFET.

9. Onduleur (2) selon l'une quelconque des revendications précédentes, **caractérisé par** une unité de traitement de région active (16) configurée pour détecter un fonctionnement d'un élément de commutation (6, 7) dans une région active et pour faire commuter l'élément de commutation pour lequel le fonctionnement dans la région active a été détecté, ou tous les éléments de commutation (6, 7) dans un état de commutation bloquant si le fonctionnement dans la région active a été détecté.

10. Ensemble (1) comprenant :
- une machine électrique (4), notamment pour véhicule (28), comprenant un stator muni d'enroulements de stator et
- un onduleur (2) selon l'une quelconque des revendications 1 à 9 configuré pour fournir une tension alternative aux enroulements de stator.

11. Véhicule (28), comprenant un ensemble (1) selon la revendication 10.

12. Procédé pour faire fonctionner un onduleur (2) comportant une liaison DC et comportant une pluralité d'éléments de commutation commandés en tension (6, 7) qui sont disposés en demi-ponts et qui sont chacun un transistor de puissance ayant une structure de transistor à effet de champ à grille isolée ou une structure de transistor à effet de champ à jonction, dans lequel l'onduleur (2) est amené à fonctionner dans un mode pulsé dans lequel des séquences d'une première tension et d'une deuxième tension sont appliquées à des bornes de commande (8) des éléments de commutation (6, 7), ladite première tension étant configurée pour mettre un élément de commutation (6, 7) dans un premier état de commutation et ladite deuxième tension étant configurée pour mettre l'élément de commutation (6, 7) dans un deuxième état de commutation, après quoi l'onduleur (2) est mis dans un mode de court-circuit actif par la commutation d'un groupe d'éléments de commutation (7) dans le premier état de commutation, sous l'effet d'une troisième tension appliquée aux bornes de commande (8) du groupe d'éléments de commutation (7), ladite troisième tension ayant une valeur absolue supérieure à la valeur absolue de la première tension, le groupe comprenant soit tous les éléments de commutation connectés à un potentiel haut de la liaison DC, soit tous les éléments de commutation (7) connectés à un potentiel bas de la liaison DC.
